# EUROPÄISCHE PATENTANMELDUNG

(11) **EP 1 724 849 A2**
(43) Veröffentlichungstag der Anmeldung: **22.11.2006**
(21) Anmeldenummer: 06005919.3
(22) Anmeldetag: 23.03.2006
(51) Int. Cl.: H01L 41/09

(54) **Piezoelektrisches Element**

(30) Priorität: 03.05.2005 DE 102005020527
(71) Anmelder: Argillon GmbH, 96254 Redwitz (DE); Festo AG & Co., 73734 Esslingen (DE)
(72) Erfinder: Günther, Jürgen, 96342 Stockheim (DE); Kremer, Hubert, 96349 Steinwiesen (DE); Rüttel, Martin, 96271 Grub am Forst (DE); Klump, Stefan, 96215 Lichtenfels (DE); Schleicher, Jürgen, 96523 Steinach (DE); Wirtl, Hannes, 86956 Schongau (DE); Maichl, Martin, 73084 Salach (DE)
(74) Vertreter: Tergau & Pohl Patentanwälte

(57) **Zusammenfassung**

Es wird ein piezoelektrisches Element (1, 14) mit einem Tragkörper (2) angegeben, auf welchem ein Piezoelektret (4) aufgebracht ist. Der Tragkörper (2) ist durch ein aufliegendes Material hindurch elektrisch kontaktiert. Das aufliegende Material erlaubt bei sicherer elektrischer Kontaktierung eine einfache mechanische Einspannung des piezoelektrischen Elements (1, 14).

## Beschreibung

Die Erfindung betrifft ein piezoelektrisches Element mit einem Tragkörper und einem darauf aufgebrachten Piezoelektreten.

Ein piezoelektrisches Element der eingangs genannten Art dient vorrangig zur Ausnutzung des indirekten oder reziproken piezoelektrischen Effekts, d.h. der Umwandlung von elektrischer in mechanische Energie. Gleichwohl eignet sich ein derartiges piezoelektrisches Element aber auch dazu, mechanische in elektrische Energie umzuwandeln. Hierbei wird der direkte piezoelektrische Effekt ausgenutzt.

Für ein piezoelektrisches Element der genannten Art gibt es eine Vielzahl von technischen Anwendungen. Solche Anwendungen sind z.b. als Druckkopf für einen Tintenstrahldrucker, als Schallaufnehmer oder Schallerzeuger in einem Mikrofon oder einem Lautsprecher, als Sensor für die Beschleunigungs- oder Druckmessung, als Ultraschall-Wandler, als präzises Verstellelement im µm-Bereich oder als Biegewandler, beispielsweise als Stellelement in Braille-Zeilen eines Blinden-Lesegeräts, in einer Textilmaschine, in einem schreibenden Messgerät oder in einem Ventil.

Aus der EP 0 455 342 B1 oder der EP 0 468 796 A1 ist ein in Schichtstruktur aufgebautes piezoelektrisches Element bekannt. Zur Verbesserung der mechanischen Stabilität des Elements oder zur Erhöhung des Wirkungsgrades wird der Piezoelektret, unter dem im folgenden ein piezoelektrisch aktives Material verstanden wird, welches den piezoelektrischen und/oder den elektrostriktiven Effekt zeigt, auf einen Tragkörper aufgebracht. Für die elektrische Kontaktierung und Ansteuerung ist der Piezoelektret mit Elektroden in Form einer flächigen Belegung aus einem leitfähigen Material versehen.

Gemäß der DE 34 34 726 C2 können auch mehrere Lagen von Piezoelektreten einschließlich der Elektroden übereinander gestapelt sein. Je nach der Anzahl der Piezoelektreten spricht man von einem mono-, bi-, tri- oder allgemein multimorphen piezoelektrischen Element. Für die Elektroden ist aus der DE 40 25 436 A1 bekannt, diese in Form einer Metallisierung auf den Piezoelektreten aufzubringen. Als Metallisierungsschicht werden wegen ihrer technischen Eigenschaften Edelmetalle eingesetzt.

Piezoelektrische Elemente mit einem Tragkörper aus einem elektrisch isolierenden Material finden sich in der DE 43 37 265 C1 sowie der DE 40 25 436 A1. Durch die Verwendung eines isolierenden Tragkörpers lassen sich bei einem bimorphen piezoelektrischen Element die dem Tragkörper zugewandten Seiten der Piezoelektreten bzw. darauf angeordnete innere Elektroden auf unterschiedliches Potential legen. Die Ansteuerung eines derartigen Elements kann ausschließlich über die innenliegenden Elektroden erfolgen, während die außenliegenden Elektroden auf Erdpotential oder Masse gelegt sind. Dadurch wird ein solches Element zudem berührsicher.

Zur elektrischen Kontaktierung der Elektroden oder des Tragkörpers wird in der DE 40 25 436 A1 die Verwendung einer aufgeklebten Metallfolie, insbesondere einer Kupferfolie, mit einer Fläche zum Anbringen eines Lötkontaktes vorgeschlagen. Hierzu ist der Tragkörper nicht ganz von dem Piezoelektreten bedeckt. Die Metallfolie ist auf dem freien Teil des Tragkörpers aufgeklebt. Gemäß der WO 97/44834 A1 kann die Kupferfolie auch zwischen Piezoelektreten und Tragkörper eingelegt werden. Aus der WO 97/44834 A1 ist weiter bekannt, freiliegende spannungsführende Teile eines piezoelektrischen Elements mit einem isolierenden Lack zu versehen.

Für den Einsatz eines piezoelektrischen Elements der eingangs genannten Art wird dieses in der Regel einseitig eingespannt, so dass ein freies Ende Bewegungen mechanisch übertragen kann. Bei der Einspannung muss dabei nachteiligerweise auf die Ausgestaltung des Kontaktierungsbereiches Rücksicht genommen werden, damit die elektrische Kontaktierung infolge der mechanischen Belastungen nicht zerstört wird.

Es ist Aufgabe der Erfindung, ein piezoelektrisches Element der eingangs genannten Art anzugeben, welches bei einer sicheren elektrischen Kontaktierung eine einfache mechanische Einspannung erlaubt.

Diese Aufgabe wird für ein piezoelektrisches Element mit einem Tragkörper und einem darauf aufgebrachten Piezoelektreten erfindungsgemäß dadurch gelöst, dass der Tragkörper durch ein aufliegendes Material hindurch elektrisch kontaktiert ist.

Bislang wurde für eine elektrische Kontaktierung des Tragkörpers oder der darauf angeordneten Elektroden der Tragkörper über den Piezoelektreten hinaus verlängert bzw. der Piezoelektret nicht bis an das Ende des Tragkörpers herangeführt. Auf dem dann freien Teil des Tragkörpers wurde die Kontaktierung vorgenommen. Die Erfindung geht nun in einem ersten Schritt von der Erkenntnis aus, dass eine derartige geometrisch komplexe Konstruktion für eine direkte mechanische Einspannung ungeeignet ist.

In einem weiteren Schritt geht die Erfindung nun von der Überlegung aus, dass ein im Kontaktierungsbereich dem Tragkörper aufliegendes Material es erlaubt, den geometrischen Aufbau des piezoelektrischen Elements zu vereinfachen. Insbesondere kann der Dickensprung des Elements auf den freien Tragkörper vermieden werden. Dies erlaubt eine einfache mechanische Einspannung. Dem Tragkörper kann dann im Bereich der Kontaktierung Material aufgelegt werden, wenn der Tragkörper durch das aufliegende Material hindurch elektrisch kontaktiert wird. Die elektrische Verbindung des Tragkörpers als solche ist dabei zusätzlich durch das umgebende Material vor äußeren Einflüssen geschützt. Das aufliegende Material kann insbesondere der Piezoelektret selbst sein.

Zur Durchkontaktierung kann das aufliegende Material über einen Metallstift oder eine Lötbrücke durchdrungen werden. Um die Dimensionierung der Kontaktierung gering zu halten, empfiehlt sich sowohl zur Kontaktierung des Tragkörpers selbst als auch zur Kontaktierung eines Anschlussdrahtes ein Kontaktierungsplättchen, insbesondere aus Kupfer, welches dem Tragkörper bzw. dem aufliegenden Material aufliegt. Ein flaches Kontaktierungsplättchen benötigt wenig Raum und führt aufgrund der flächigen Ausdehnung zu einem guten elektrischen Kontakt. Zudem liefert es auf dem aufliegenden Material wenig Angriffsfläche.

Der Tragkörper selbst kann prinzipiell aus jedem beliebigen geeigneten Material sein. Insbesondere kann je nach Anforderung als Material ein Metall, ein Kunststoff oder ein Verbundmaterial verwendet werden. Insbesondere kann als Material für den Tragkörper ein Duroplast wie ein Epoxidharz eingesetzt werden. Der Tragkörper kann insbesondere die Form eines flachen Plättchens aufweisen. Ein derartiges Element eignet sich für die Verwendung als ein Biegewandler oder Aktor. Derartige Biegewandler werden in der Textilindustrie zur Ansteuerung von Web-, Wirk- oder Strickmaschinen, insbesondere für die Erzeugung von Mustern mit Hilfe der Jacquard-Technik, eingesetzt. Des Weiteren wird ein solcher Aktor für Blinden-Lesegeräte zur Betätigung einzelner Tastenelemente, in Pneumatik-Ventilen oder Video-/Audio-Geräten eingesetzt.

Vorzugsweise besteht der Tragkörper aus einem elektrisch leitfähigen Material. In diesem Fall wirkt der Tragkörper zugleich als eine Innenelektrode. Ein weiterer Vorteil dieser Ausgestaltung ist darin zu sehen, dass bei einer Ausführungsform mit beidseitig am Tragkörper vorgesehenen Piezoelektreten eine einzige elektrische Durchkontaktierung durch das aufliegende Material ausreicht.

Für den Fall eines Tragkörpers aus einem elektrisch isolierenden Material, z.B. aus einem Glasfasermaterial, ist zweckmäßigerweise zwischen dem Tragkörper und dem Piezoelektreten eine Innenelektrode angeordnet, wobei diese durch das aufliegende Material hindurch elektrisch kontaktiert ist. Dabei kann die Innenelektrode insbesondere auch auf den Teil des Tragkörpers erstreckt sein, der von dem aufliegenden Material bedeckt ist. Ebensogut kann aber auch zwischen der Elektrode und dem Tragkörper ein Metallplättchen, insbesondere aus Kupfer, eingelegt sein.

In einer vorteilhaften Alternative weist der Piezoelektret und das piezoelektrisch inaktive Material dieselbe Materialdicke auf. Auf diese Weise kann ein symmetrisches Element hergestellt werden, welches zwischen dem Piezoelektret und dem aufliegenden Material keine Stufe aufweist. Dies ist sowohl für die Einspannung als auch für die Kraftübertragung vorteilhaft. Zudem grenzt der Piezoelektret dadurch in seiner ganzen Höhe an das aufliegende Material an, wodurch sich bei geeigneter Wahl des aufliegenden Materials ohne eine weitere Maßnahme ein Schutz des Piezoelektreten vor äußeren Einflüssen ergibt.

Vorteilhafterweise wird für das aufliegende Material ein piezoelektrisch inaktives Material verwendet. Dadurch ist der Piezoelektret als solcher durch seine Einbettung in das inaktive Material gleichzeitig zusätzlich vor äußeren Einflüssen, beispielsweise vor Feuchtigkeit oder vor Betriebsstoffen wie Öle oder Chemikalien, geschützt. Es genügt daher, lediglich die Oberfläche des Piezoelektreten und nicht das ganze piezoelektrische Element vor äußeren Einflüssen zu schützen. Da sich der Piezoelektret nicht auf den Einspannbereich erstreckt, kann dort auch kein Abrieb einer auf den Piezoelektreten aufgetragenen Schutzschicht oder Versiegelung auftreten.

Weiter wirken die Belastungen im Einspannbereich nicht mehr auf den Piezoelektreten sondern auf das inaktive Material, welches aber hinsichtlich der Funktionsfähigkeit des piezoelektrischen Elements keinen Beitrag leistet.

Als inaktives Material kann grundsätzlich jedes Material verwendet werden, welches genügend mechanisch belastbar ist. Zweckmäßigerweise ist das piezoelektrisch inaktive Material ein Kunststoff, insbesondere ein Leiterplattenkunststoff, oder eine Keramik, insbesondere eine unpolarisierte Piezokeramik. Derartiges Material ist mechanisch genügend belastbar und wird für den Aufbau des piezoelektrischen Elements ohnehin benötigt. Es steht demnach kostengünstig zur Verfügung und muss nicht zusätzlich eingekauft werden.

Für den Piezoelektreten sind prinzipiell alle Materialien geeignet, welche den piezoelektrischen bzw. elektrostriktiven Effekt zeigen. In einer vorteilhaften Ausgestaltung ist der Piezoelektret als eine polarisierte Piezokeramik ausgeführt. Dabei sind wiederum bestimmte Oxidkeramiken, z.B. Blei-Zirkonat-Titan (PZT), zu bevorzugen, die über ihre Zusammensetzung eine Anpassung an unterschiedliche Anforderungen erlauben. Zur Herstellung der Funktionsfähigkeit muss eine als Piezoelektret verwendete Piezokeramik zunächst in einem homogenen elektrischen Feld von einigen KV / mm polarisiert werden. Auf diese Weise wird in dem Piezoelektreten eine polare Achse erzeugt, die für das Auftreten des piezoelektrischen Effekts notwendig ist. Durch Anlegen einer genügend hohen elektrischen Spannung an zur Ansteuerung auf die Piezokeramik aufgebrachte flächige Elektroden, beispielsweise in Form einer flächigen Metallisierung, läßt sich ein weitgehend homogenes elektrisches Feld erzeugen, welches eine effektive Polarisation ermöglicht.

Weiter von Vorteil ist es, wenn dem Piezoelektreten eine Außenelektrode aufliegt, die teilweise das aufliegende Material übergreift und dort elektrisch kontaktiert ist. Die Außenelektrode kann beispielsweise in Form einer Metallisierung, z.B. Leitsilber, auf den Piezoelektreten aufgebracht sein. Auch kann die Elektrode eine leitfähige Schicht, beispielsweise in Form eines Lackes oder eines Kunststoffüberzuges, insbesondere ein Karbonlack oder ein Leitkleber, ausgestaltet sein. Durch die Ausdehnung der Außenelektrode auf das aufliegende Material wird die elektrische Kontaktierung von dem Piezoelektreten weggezogen. Eine chemische, thermische oder mechanische Belastung des Piezoelektreten bei der Kontaktierung durch Kleben, Löten, Einpressen bzw. durch Belastung mit Federkontakten entfällt.

Eine sichere elektrische Kontaktierung erfolgt über ein zwischen der Außenelektrode und dem inaktiven Material eingelegtes Kupferplättchen. Hierzu weist das Kupferplättchen eine Oberfläche für einen Lötkontakt mit einem Anschlussdraht auf. Selbstverständlich eignen sich auch andere Metalle für das eingelegte Kontaktierungsplättchen; aufgrund der hohen Leitfähigkeit und der guten Kontaktierungseigenschaften ist aber Kupfer zu bevorzugen. Durch die Benutzung des eingelegten Kontaktierungsplättchens kann die elektrische Kontaktierung in einfacher Art und Weise von dem Piezoelektreten weiter auf das inaktive Material hinaus verlegt werden.

Gemäß einer bevorzugten alternativen Ausgestaltung ist zur Kontaktierung der Außenelektrode eine insbesondere nach Art einer Leiterbahn aufgebrachte Weiterkontaktierung vorgesehen, die die vollflächig auf den Piezoelektreten aufgebrachte Außenelektrode mit dem in das inaktive Material eingelegten Kupferplättchen kontaktiert.

In einer weiteren vorteilhaften Ausgestaltung des piezoelektrischen Elements ist der Piezoelektret in mechanischen Belastungsbereichen durch das inaktive Material ersetzt. Ein derartiger Belastungsbereich ist beispielsweise der bereits erwähnte Einspannbereich oder ein Kraftübertragungsbereich. Durch die Einspannung des piezoelektrischen Elements oder infolge der mechanischen Kraftübertragung ist dieses zusätzlichen mechanischen Belastungen wie beispielsweise Druck- und Zugspannungen ausgesetzt. Dabei ist es unerheblich, ob das piezoelektrische Element mit einem Kleber fixiert oder durch Einklemmung mechanisch festgehalten wird. Häufig wird auch im Bereich der Kraftübertragung ein Wirk- oder Kopplungselement aufgesetzt, welches selbst als ein Betätigungselement wirkt oder dessen Stellung abgetastet wird. Auch das aufgesetzte Kopplungselement, unabhängig ob durch Klebung oder Klemmung, führt zu einer vermehrten äußeren mechanischen Belastung des Piezoelektreten. Bei herkömmlichen piezoelektrischen Elementen wirkt die zusätzliche mechanische Belastung direkt auf den Piezoelektreten ein. Der funktionsfähige Piezoelektret ist entweder selbst eingespannt oder direkt an der Kraftübertragung beteiligt, wodurch ein Verschleiß des Piezoeletreten auftritt. Durch Verschleiß des Piezoelektreten verkürzt sich aber die Lebensdauer des gesamten Elements. Bleibt der Piezoelektret aber von derartigen mechanischen Belastungen verschont, wird ein unnötiger Verschleiß vermieden. Die Lebensdauer erhöht sich.

Durch den Ersatz des Piezoelektreten durch inaktives Material in mechanischen Belastungsbereichen bleibt der die Funktionsfähigkeit herstellende Piezoelektret an diesen Stellen vor unnötigen äußeren mechanischen Belastungen verschont. Das piezoelektrische Element kann problemlos mechanisch fest eingespannt werden. Der Piezoelektret verbleibt im freien Bewegungsgebiet. Es hat sich dabei durch Untersuchungen gezeigt, dass ein um die Fläche der mechanischen Belastungsbereiche reduzierter Piezoelektret nicht die physikalischen Werte des piezoelektrischen Elements hinsichtlich Biegekraft und Umsetzungsgrad von elektrischer in mechanische Energie verringert.

Für den Schutz des Piezoelektreten vor den eingangs bereits erwähnten äußeren Einflüssen ist es sinnvoll, diesen mit einer Schutzoberfläche, insbesondere einem Schutzlack, zu überziehen. Auf dem Teil des piezoelektrischen Elements, an welchem der Piezoelektret durch das inaktive Material ersetzt ist, braucht keine Schutzoberfläche aufgebracht sein. Hierdurch können für das Element enge Toleranzen für die Einbau- und Funktionsposition erreicht werden. Die elektrischen und mechanischen Funktionsflächen bleiben zudem frei zugänglich. Als Schutzoberfläche eignet neben einem Lack auch noch ein Harz, ein Öl oder ein Wachs. Ebenso kann ein Kunststoffüberzug beispielsweise in Form eines Schrumpfschlauches oder eines Folienüberzugs, verwendet werden.

Ausführungsbeispiele der Erfindung werden anhand einer Zeichnung näher erläutert. Dabei zeigen:
- Figur 1: in einem Querschnitt schematisch den Aufbau eines piezoelektrischen Elements mit einem leitfähigen Tragkörper,
- Figur 2: in einer Draufsicht das piezoelektrische Element gemäß Figur 1,
- Figur 3: in einem Querschnitt schematisch den Aufbau eines piezoelektrischen Elements mit einem Tragkörper aus einem elektrisch isolierenden Material,
- Figur 4: ein als Biegewandler ausgestaltetes piezoelektrisches Element, welches eingespannt und an seinem freien Ende mit einem Wirkelement versehen ist und
- Figur 5: in einem Querschnitt schematisch den Aufbau eines piezoelektrischen Elements mit einem leitfähigen Tragkörper in einer zu Figur 1 alternativen Ausgestaltung,

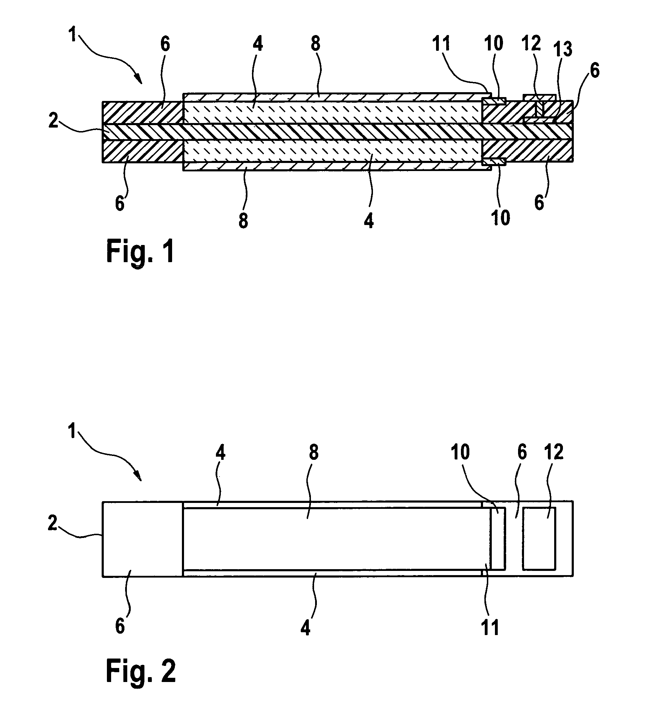

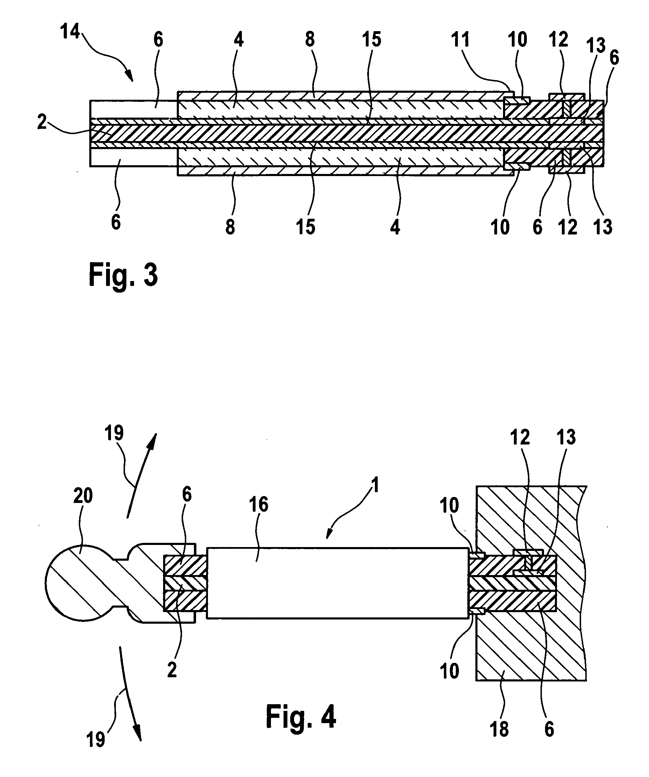

Figur 1 zeigt in einem Querschnitt schematisch anhand eines Biegewandlers den Aufbau eines piezoelektrischen Elements 1. Als Tragkörper 2 ist ein flaches Plättchen aus einem elektrisch leitfähigen, kohlefaserverstärkten Verbundkunststoff eingesetzt. Auf beiden Seiten des Tragkörpers 2 ist jeweils ein Piezoelektret 4 aufgebracht. Als Material für den Piezoelektreten 4 ist eine PZT-Keramik verwendet. An beiden Enden des Tragkörpers 2 ist der Piezoelektret 4 durch ein piezoelektrisch inaktives Material 6 aus GFK (GFK = Glasfaserverstärkter Kunststoff) ersetzt. Die Enden eines Biegewandlers stellen dabei mechanische Belastungsbereiche dar, denn der Biegewandler wird in der Regel an einem Ende fest eingespannt, während das andere frei bewegliche Ende zur Übertragung einer Kraftkomponente benutzt wird. Dies wird auch aus Figur 4 ersichtlich.

Das inaktive Material 6 weist dieselbe Dicke wie der Piezoelektret 2 auf. Auf die Oberfläche des Piezoelektreten 2 ist - nicht maßstabsgetreu gezeigt - beidseitig jeweils eine Außenelektrode 8 in Form einer Metallisierungsschicht aufgetragen. Zur elektrischen Kontaktierung mittels eines Kupferplättchens 10 weist jede Außenelektrode 8 auf einer Seite einen Überstand 11 auf. Das Kupferplättchen 10 ist gewissermaßen zwischen der Außenelektrode 8 und dem inaktiven Material 6 eingelegt. Hierdurch kommt ein sicherer und guter elektrischer Kontakt zustand.

Der Tragkörper 2 selbst ist durch das inaktive Material 6 hindurch kontaktiert. Hierzu ist ein äußeres Kupferplättchen 12 dem inaktiven Material 6 aufgelegt und durch dieses über eine Lötbrücke nach Art einer Leiterplattendurchkontaktierung mit einem auf dem Tragkörper 2 angeordneten inneren Kupferplättchen 13 elektrisch verbunden.

Wird zwischen Tragkörper 2 und einer Außenelektrode 4 eine Spannung angelegt, so erfährt die Piezokeramik des Piezoelektreten 2 je nach Orientierung des entstehenden elektrischen Feldes eine Längenausdehnung oder eine Längenverkürzung. Der Biegewandler krümmt bzw. verbiegt sich.

In Figur 2 ist das piezoelektrische Element 1 gemäß Figur 1 in einer Draufsicht dargestellt. Man erkennt deutlich die auf den Piezoelektreten 4 aufgebrachte Au-βenelektrode 8 sowie das an beiden Enden des piezoelektrischen Elements 1 den Piezoelektreten 4 ersetzende inaktive Material 6. Unter den Überstand 11 der Au-βenelektrode 8 ist das Kupferplättchen 10 eingelegt. Über das äußere Kupferplättchen 12 ist der Tragkörper 2 elektrisch kontaktiert.

Im Unterschied zu dem in Figur 1 dargestellten piezoelektrischen Element 1 weist das in Figur 3 gezeigte piezoelektrische Element 14 einen Tragkörper 2 aus einem elektrisch isolierenden GFK-Material auf. Aus diesem Grund sind beidseitig des Tragkörpers flächige Innenelektroden 15 in Form einer Metallisierungsschicht aufgebracht, um an der Piezokeramik das zur Ansteuerung erforderliche elektrische Feld erzeugen zu können. Die Innenelektroden 15 sind jeweils unter das inaktive Material 6 gezogen und dort mittels innerer Kupferplättchen 13 durch das Material 6 hindurch mit äußeren Kupferplättchen 12 kontaktiert. Da der Tragkörper 2 elektrisch isolierend ist, können beide Innenelektroden 15 auf unterschiedliches Potential gelegt werden. Die Außenelektroden 8 können daher auf Erdpotential gelegt werden, und das piezoelektrische Element 14 alleine durch die Innenelektroden 15 angesteuert werden.

Figur 4 zeigt das als Biegewandler ausgestaltete piezoelektrische Element 1 in seiner Funktionsposition. Im Unterschied zu den vorherigen Figuren ist in Figur 4 der den Piezoelektreten abdeckende Schutzlack 16 dargestellt. Der Schutzlack 16 erstreckt sich nicht auf die inaktiven Materialien 6. Als Schutzlack 16 ist ein feuchtigkeitsundurchlässiges, elektrisch isolierendes Polymerharz aufgetragen.

An einem Ende ist das piezoelektrische Element 1 mechanisch fest in ein Fixierungselement 18 eingespannt. Dabei wird die Kontaktierung zu den Kupferplättchen 10 und 12 über nicht dargestellte Kontaktstifte hergestellt. Diese sind Teil des Fixierungselements 18 und im Bereich der Kupferplättchen 10 und 12 angeordnet. Wird zwischen die Kupferplättchen 10 und 12 eine elektrische Spannung angelegt, so krümmt sich der Biegewandler aufgrund der Dehnung oder Verkürzung der Piezoelektreten 6. Das freie Ende des Biegewandlers wird dadurch in Richtung der Pfeile nach oben oder nach unten ausgelenkt. Zum Abgriff der Auslenkung des freien Endes ist dort ein Wirkelement 20 dem piezoelektrischen Element 1 aufgepresst.

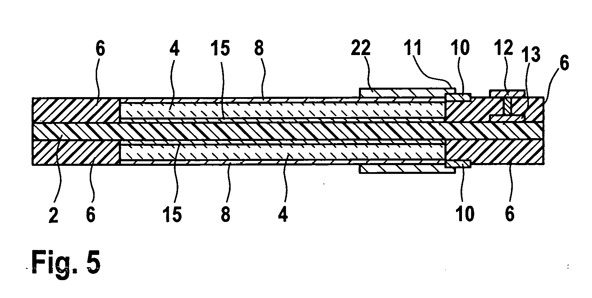

Das in Figur 5 dargestellte piezoelektrische Element 1 weist im Wesentlichen den gleichen Aufbau wie das in Figur 1 dargestellte piezoelektrische Element 1 auf. Im Unterschied zu der in Figur 1 dargestellten Ausführungsform sind die Außenelektroden 8 mittelbar über eine jeweilige Weiterkontaktierung 22 mit dem jeweiligen Kupferplättchen 10 kontaktiert. Die Weiterkontaktierung 22 ist hierbei insbesondere eine beispielsweie im Siebdruckverfahren aufgebrachte Leiterbahn, die im Unterschied zur Außenelektrode 8 den Piezoelektreten 4 nicht vollflächig überdeckt. Die Außenelektrode 8 ist bevorzugt über einen Sputterprozess aufgebracht und weist eine Dicke im nm-Bereich oder auch im µm-Bereich auf. Der Aufbau mit der Weiterkontaktierung 22 ist herstellungstechnisch besonders einfach zu verwirklichen.

Zur Herstellung des piezoelektrischen Elements 1 gemäß den Figuren 1 und 5 wird der Tragkörper 2 in Form eines Kohlefaserprepregs (Prepreg = noch nicht ausgehärteter Verbundkunststoff), die inaktiven Materialstücke 6 in Form eines Glasfaserprepregs und die Piezokeramiken 4 in Form gelegt, miteinander verpresst und das Element anschließend ausgehärtet. Das für die Materialstücke 6 verwendete Material ist hierbei bevorzugt Material, wie es für die Herstellung von Leiterplatten verwendet wird. Die Außenelektroden 8 sowie die Weiterkontaktierung 22 werden nachträglich aufgebracht; die zur elektrischen Kontaktierung vorgesehen Kupferplättchen 10 und 12 sind auf das inaktive Material 6 aufgeklebt. Das innere Kupferplättchen 13 wird vorab bereits miteingelegt. Die beiden Kupferplättchen sind über eine leitende Verbindung miteinander verbunden.

### Bezugszeichenliste

- 1: Piezoelektrisches Element
- 2: Tragkörper
- 4: Piezoelektret
- 6: GFK-Material
- 8: Außenelektrode
- 10: Kupferplättchen
- 11: Überstand
- 12: Kupferpad
- 13: Kupferpad
- 14: Piezoelektrisches Element
- 15: Innenelektrode
- 16: Schutzlack
- 18: Fixierungselement
- 20: Wirkelement
- 22: Weiterkontaktierung

## Patentansprüche

1. Piezoelektrisches Element (1, 14) mit einem Tragkörper (2) und einem darauf aufgebrachten Piezoelektreten (4), **dadurch gekennzeichnet, dass** der Tragkörper (2) durch ein aufliegendes Material (6) hindurch elektrisch kontaktiert ist.

2. Piezoelektrisches Element (1, 14) nach Anspruch 1, **dadurch gekennzeichnet, dass** der Tragkörper (2) elektrisch leitfähig ist.

3. Piezoelektrisches Element (1, 14) nach Anspruch 1, **dadurch gekennzeichnet, dass** der Tragkörper (2) aus einem elektrisch isolierenden Material besteht, dass zwischen dem Tragkörper (2) und dem Piezoelektreten (4) eine Innenelektrode (15) angeordnet ist, und dass diese durch das aufliegende Material (6) hindurch elektrisch kontaktiert ist.

4. Piezoelektrisches Element (1, 14) nach einem der Ansprüche1 bis 3, **dadurch gekennzeichnet, dass** der Piezoelektret (2) und das aufliegende Material (6) dieselbe Materialdicke aufweisen.

5. Piezoelektrisches Element (1, 14) nach einem der Ansprüche 1 bis 4, **dadurch gekennzeichnet,dass** das aufliegende Material ein piezoelektrisch inaktives Material (6) ist.

6. Piezoelektrisches Element (1, 14) nach Anspruch 5, **dadurch gekennzeichnet, dass** das piezoelektrisch inaktive Material (6) ein Kunststoff, insbesondere ein Leiterplattenkunststoff, oder eine Keramik, insbesondere eine unpolarisierte Piezokeramik, ist.

7. Piezoelektrisches Element (1, 14) nach einem der Ansprüche 1 bis 6, **dadurch gekennzeichnet, dass** der Piezoelektret (4) eine polarisierte Piezokeramik ist.

8. Piezoelektrisches Element (1, 14) nach einem der Ansprüche 1 bis 7, **dadurch gekennzeichnet, dass** auf dem Piezoelektreten (4) eine Au-βenelektrode (8) aufliegt, die teilweise das aufliegende Material übergreift und dort elektrisch kontaktiert ist.

9. Piezoelektrisches Element (1, 14) nach Anspruch 8, **dadurch gekennzeichnet, dass** die elektrische Kontaktierung über ein zwischen der Au-βenelektrode (8) und dem aufliegenden Material eingelegtes Kupferplättchen (10) erfolgt.

10. Piezoelektrisches Element (1, 14) nach einem der Ansprüche 1 bis 7, **dadurch gekennzeichnet, dass** eine Außenelektrode (8) des Piezoelektreten (4) über eine von der Außenelektrode (8) zu dem aufliegenden Material (6) geführte Weiterkontaktierung (22) kontaktiert ist.

11. Piezoelektrisches Element (1, 14) nach einem der Ansprüche 5 bis 10, **dadurch gekennzeichnet, dass** der Piezoelektret (4) in einem mechanischen Belastungsbereich durch das inaktive Material (6) ersetzt ist.

12. Piezoelektrisches Element (1, 14) nach einem der Ansprüche 1 bis 11, **dadurch gekennzeichnet, dass** der Piezoelektret (4) mit einer Schutzoberfläche, insbesondere einem Schutzlack (16), überzogen ist.
